(19) Europäisches Patentamt
European Patent Office
Office européen des brevets

(11) EP 2 857 470 A1

(12) # EUROPEAN PATENT APPLICATION
published in accordance with Art. 153(4) EPC

(43) Date of publication:
**08.04.2015 Bulletin 2015/15**

(21) Application number: **13797952.2**

(22) Date of filing: **21.05.2013**

(51) Int Cl.:
***C09J 7/02*** (2006.01) ***C09J 11/04*** (2006.01)
***C09J 11/06*** (2006.01) ***C09J 163/00*** (2006.01)
***C09J 179/08*** (2006.01) ***H01L 21/60*** (2006.01)
***H01L 23/29*** (2006.01) ***H01L 23/31*** (2006.01)

(86) International application number:
**PCT/JP2013/064036**

(87) International publication number:
**WO 2013/179943 (05.12.2013 Gazette 2013/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **30.05.2012 JP 2012123146**

(71) Applicant: **Toray Industries, Inc.**
**Tokyo 103-8666 (JP)**

(72) Inventors:
- **MATSUMURA, Kazuyuki**
**Otsu-shi**
**Shiga 520-8558 (JP)**
- **FUJIMARU, Koichi**
**Otsu-shi**
**Shiga 520-8558 (JP)**
- **NONAKA, Toshihisa**
**Otsu-shi**
**Shiga 520-8558 (JP)**

(74) Representative: **Hoefer & Partner**
**Pilgersheimer Straße 20**
**81543 München (DE)**

(54) **ADHESIVE SHEET FOR PRODUCTION OF SEMICONDUCTOR DEVICE HAVING BUMP ELECTRODES AND PRODUCTION METHOD FOR SEMICONDUCTOR DEVICE**

(57) An adhesive sheet for production of a semiconductor device with bump electrode, including a soft film and an alkali-soluble adhesive film formed on the soft film is capable of exposing the bump electrode without imparting damage to the bump electrode, and then wet etching of an adhesive on bump tops using an aqueous alkali solution makes it possible to put into a state where no adhesive exists on the bump tops, thus enabling the production of a semiconductor device which is excellent in connection reliability after flip chip packaging.

Fig. 1

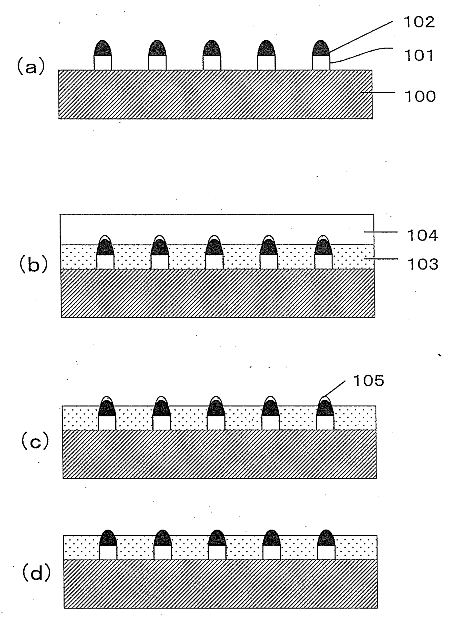


EP 2 857 470 A1

## Description

[Technical Field]

The present invention relates to an adhesive sheet for production of a semiconductor device with bump electrode, and a method for production of a semiconductor device using the same.

[Background Art]

With recent advancement of miniaturization and high densification of a semiconductor device, flip chip packaging has attracted great attention as a method for packaging a semiconductor chip on a circuit board, leading to the rapid spread. In the flip chip packaging, there has been employed, as a common method for bonding of a semiconductor chip, a method in which an epoxy resin-based adhesive is interposed between a bump electrode formed on the semiconductor chip and a pad electrode of the circuit board. There has also been proposed a technique in which, using an adhesive sheet in which an adhesive film is laminated on a flexible film, an adhesive is laminated on a semiconductor chip without covering a bump electrode, followed by packaging on a circuit board, thus improving electric connection reliability between the semiconductor chip and the circuit board (see, for example, Patent Literatures 1 and 2).

[Citation List]

[Patent Literature]

[Patent Literature 1]

Japanese Unexamined Patent Publication (Kokai) No. 2005-28734

[Patent Literature 2]

Japanese Unexamined Patent Publication (Kokai) No. 2011-171586

[Summary of Invention]

[Technical Problem]

When the adhesive is laminated on the semiconductor chip using the adhesive sheet mentioned above, it was possible to exposure the bump electrode to some extent, but it was impossible to put into a state where no adhesive exists on tops (bump tops) of the bump electrode. As a result, it was difficult to ensure sufficient connection reliability by interposing the adhesive between the bump electrode of the semiconductor chip and the pad electrode of the circuit board after packaging.

In view of these circumstances, an object of the present invention is to provide an adhesive sheet capable of putting into a state where no adhesive exists on bump tops without imparting damage to a bump electrode when an adhesive is laminated on a semiconductor chip using the adhesive sheet, thus enabling the production of a semiconductor device which is excellent in connection reliability between the bump electrode of a semiconductor chip and a pad electrode of a circuit board after flip chip packaging.

[Solution to Problem]

Namely, the present invention is directed to an adhesive sheet for production of a semiconductor device with bump electrode, in which an alkali-soluble adhesive film is formed on a soft film.

The present invention also includes a method for production of a semiconductor device, which includes the steps of: laminating a face of the alkali-soluble adhesive film side of the adhesive sheet for production of a semiconductor device with bump electrode according to any one of claims 1 to 7 on a face of the bump electrode side of a first circuit member including a bump electrode; leaving only the alkali-soluble adhesive film of the adhesive sheet on the circuit member, andpeeling other films included in the adhesive sheet; etching the alkali-soluble adhesive film with an aqueous alkali solution to remove the adhesive on the bump electrode; and electrically connecting the first circuit member with a second circuit member including a pad electrode by applying heat and pressure, in this order.

[Advantageous Effects of Invention]

When an adhesive is laminated on a semiconductor chip using an adhesive sheet of the present invention, it is possible to expose a bump electrode without imparting damage to the bump electrode. Then, wet etching of the adhesive on bump tops using an aqueous alkali solution makes it possible to put into a state where no adhesive exists on the bump tops, thus enabling the production of a semiconductor device which is excellent in connection reliability between a semiconductor chip and a circuit board after flip chip packaging.

[BRIEF DESCRIPTION OF THE DRAWINGS]

Fig. 1 is a schematic view showing an example of a process of forming an adhesive film on a circuit member with bump electrode using an adhesive sheet for production of a semiconductor device with bump electrode of the present invention.

[Description of Embodiments]

The adhesive sheet for production of a semiconductor device with bump electrode of the present invention is obtained by forming an alkali-soluble adhesive film on a soft film.

The adhesive sheet of the present invention is used for production of a semiconductor device with bump electrode. The semiconductor device as used in the present invention means all apparatuses which are capable of functioning by utilizing properties of a semiconductor device. The semiconductor device entirely includes a semiconductor device connected to a substrate, semiconductor devices connected to each other or substrates connected to each other, an electrooptic device, a semiconductor circuit board, and electronic parts including them. The adhesive sheet of the present invention can be suitably used for bonding or fixing of members used in these semiconductor devices, or used as an adhesive for semiconductor for sealing of a semiconductor device.

An example of usage of an adhesive sheet of the present invention will be described with reference to Fig. 1. First, a circuit member with bump electrode 100 is prepared (Fig. 1(a)). Here, the circuit member is that in which a circuit is disposed on a substrate, for example, a semiconductor substrate such as a silicon substrate, a compound semiconductor substrate, anorganic circuit board, an inorganic circuit board, or the like. It is also possible to use a semiconductor chip as the silicon substrate. Examples of the organic circuit board include a glass base material copper clad laminate such as a glass cloth-epoxy copper clad laminate; a composite copper clad laminate such as a glass nonwoven fabric-epoxy copper clad laminate; a heat-resistant/thermoplastic substrate such as a polyetherimide resin substrate, a polyether ketone resin substrate, or a polysulfone-based resin substrate; a polyester copper clad film substrate; and a flexible substrate such as a polyimide copper clad film substrate. Examples of the inorganic circuit board include ceramic substrates such as an alumina substrate, an aluminum nitride substrate, and a silicon carbide substrate; and metal-based substrates such as an aluminum base substrate and an iron base substrate. Examples of constituent materials of the circuit include a conductor containing metals such as silver, gold, and copper, a resistive element containing an inorganic oxide, a low dielectric material containing a glass-based material and/or a resin, a high dielectric material containing a resin or high dielectric inorganic particles, an insulator containing a glass-based material.

In a circuit member with bump electrode, the bump electrode is formed on these substrates. Examples of the material of the bump electrode include silver, gold, copper, solder, and the like. Due to a necessity of electrical connection between the bump electrode and the pad electrode of other circuit members, the material of the bump electrode is preferably solder. Furthermore, in order to deal with a narrow pitch of bumps, a solder bump is preferably formed on a metal pillar, especially a copper pillar. In a circuit member with bump electrode 100 shown in Fig. 1(a), a solder bump 102 is formed on a copper pillar 101.

Next, a face of the bump electrode side of the circuit member with bump electrode is allowed to face a face of the alkali-soluble adhesive film side of the adhesive sheet of the present invention, followed by lamination due to thermal bonding (Fig. 1(b)). In this case, use of a soft film 104 as a support of an alkali-soluble adhesive film 103 enables bump exposure without imparting damage and deformation to the bump electrode, as shown in Fig. 1 (b) . Here, bump exposure means a state where the thickness of the alkali-soluble adhesive film after lamination is equivalent to or less than the height of the bump electrode.

Next, only the alkali-soluble adhesive film 103 is left on the circuit member with bump electrode by peeling the soft film 104 to obtain a circuit member with bump electrode on which an alkali-soluble adhesive coated film is formed (Fig. 1(c)). As shown in Fig. 1(c), tops (bump tops) of the bump electrode are exposed, in other words, although the bump tops protrudes above the alkali-soluble adhesive coated film, a small amount of an alkali-soluble adhesive 105 adheres on the bump tops.

Next, the alkali-soluble adhesive on the bump tops is removed by etching, thus putting into a state where no alkali-soluble adhesive exists on the bump tops (Fig. 1(d)). Etching of the alkali-soluble adhesive is performed by wet

etching using an aqueous alkali solution.

The material of the adhesive sheet of the present invention will be described below. In the adhesive sheet of the present invention, an alkali-soluble adhesive film is formed on a soft film.

The soft film is a film serving as a support of the alkali-soluble adhesive film. The soft film having a tensile elastic modulus of 1 to 300 MPa at 40 to 80°C is preferable. It is possible to use, as such soft film, a polyethylene (PE) film, an ethylene-vinyl acetate copolymer (EVA) film, a polyvinyl chloride film, a polyethylene methyl acrylate film, a polyethylene methyl methacrylate film, a polyurethane film, a polytetrafluoroethylene film, a polyvinyl acetal film, and the like. These soft films may be used alone, or two or more thereof may be used in combination. Of the soft films mentioned above, a PE film or an EVA film is preferable in view of satisfactory adhesion to the alkali-soluble adhesive film, and satisfactory peelability after lamination of an adhesive sheet on a base material.

The thickness of the soft film is not particularly limited and is preferably 5 μm or more, and more preferably 10 μm or more in view of suppression of damage of a bump electrode. In view of making it easy to perform alkali etching by pushing away the alkali-soluble adhesive on the bump electrode, the thickness of the soft film is preferably 200 μm or less, and more preferably 150 μm or less.

The alkali-soluble adhesive film is formed on the soft film mentioned above. The alkali-soluble adhesive film may be in contact with the soft film, and other films may be further laminated. Accordingly, a support film of the alkali-soluble adhesive film may be either a soft film alone or a film obtained by laminating a soft film on a different film. In view of ease of handling when formed into an adhesive sheet, the support film is preferably a film obtained by laminating a soft film on a hard film. In view of suppression of warp of an adhesive sheet generated by heating or cooling of an adhesive sheet using the soft film, the support film is more preferably a film in which a soft film, a hard film, and a soft film are laminated in this order. It is possible to use, as the hard film, a polyethylene terephthalate (PET) film, a polypropylene film, a polycarbonate film, a polyimide film, and the like

In the present invention, the fact that the alkali-soluble adhesive film is alkali-soluble means that, when the film is immersed in an aqueous 2.38% solution of tetramethylammonium hydroxide at 23°C for 10 minutes, the film thickness of the film decreases by 0.1 μm or more.

In view of that fact that alkali solubility of the alkali-soluble adhesive film enables easy etching of a resin on bump tops and thus the connection resistance value after flip chip packaging becomes less likely to increase, the rate of etching with an aqueous 2.38% tetramethylammonium hydroxide solution at 23°C is preferably 0.5 μm/minute or more, and more preferably 1.0 μm/minute or more. In view of making it easy to control the amount of etching of the portion where the adhesive is desirably left, the etching rate is preferably 100 μm/minute or less, more preferably 50 μm/minute or less, and most preferably 10 μm/minute or less. Alkali solubility of the alkali-soluble adhesive film can be adjusted by the kind and the content ratio of the respective components which constitute the alkali-soluble adhesive film mentioned below.

The thickness of the alkali-soluble adhesive film is not particularly limited and is preferably 5 μm or more in view of the fact that the adhesive strength of the semiconductor device fabricated using the adhesive sheet is retained, thus improving connection reliability. In view of the fact that drying of the solvent can be satisfactorily performed when the alkali-soluble adhesive film is fabricated and voids caused by residual solvent after semiconductor packaging can be suppressed, thus improving connection reliability of the semiconductor device, the thickness of the alkali-soluble adhesive film is preferably 100 μm or less.

It is preferred that the alkali-soluble adhesive film contains (A) an alkali-soluble resin, (B) an epoxy compound, (C) a hardening accelerator, and (D) inorganic particles.

The alkali-soluble resin (A) means a resin which dissolves in 100 g of an aqueous 2.38% solution of tetramethylammonium hydroxide at 25°C (in the amount of 0.1 g or more). In order to make it easy to etch with an aqueous alkali solution, the alkali-soluble resin (A) preferably has an alkali-soluble functional group. The alkali-soluble functional group is a functional group having acidity, and specific examples thereof include a phenolic hydroxyl group, a carboxyl group, a sulfonic acid group, and a thiol group. Due to storage stability of the alkali-soluble adhesive film, and problems such as corrosion to copper wiring, aluminum wiring, and solder bump as conductors, the alkali-soluble group is preferably a phenolic hydroxyl group.

The alkali-soluble resin is not particularly limited as long as it is alkali-soluble and includes, for example, a polyimide resin, a polyamide resin, a phenoxy resin, a polysulfone resin, a polyphenylene sulfide resin, a polyester resin, a polyether ketone resin, a polyether resin, a (meth) acryl copolymer, and the like. These alkali-soluble resins are used alone, or two or more kinds thereof are used in combination. Of the alkali-soluble resins mentioned above, an alkali-soluble polyimide is preferable in view of satisfactory heat resistance and excellent reliability capable of retaining satisfactory connection as an adhesive.

Introduction of an alkali-soluble functional group into polyimide can be performed by allowing diamine, tetracarboxylic dianhydride, or a terminal-sealing agent to have an alkali-soluble group. When an imidization ratio of polyimide is less than 100%, although a carboxyl group derived from tetracarboxylic dianhydride is left, the carboxyl group is not included in the alkali-soluble group used herein.

The alkali-soluble polyimide used preferably in the present invention includes a structural unit represented by the following general formula (1), and also includes structure(s) represented by the following general formula (s) (2) and/or (3) in at at least one main chain terminal.

[Chemical Formula 1]

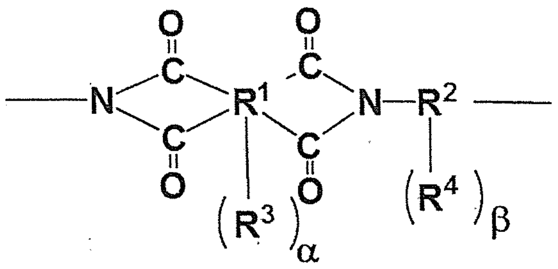

(1)

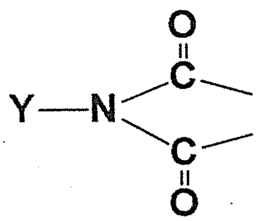

(2)

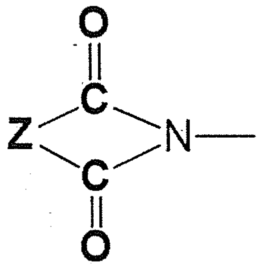

(3)

In the above general formulas (1) to (3), $R^1$ represents a tetra- to tetradecavalent organic group and $R^2$ represents a di-to dodecavalent organic group. $R^3$ and $R^4$ may be the same or different and represent at least one group selected from the group consisting of a carboxyl group, a phenolic hydroxyl group, a sulfonic acid group, and a thiol group. $R^3$ and $R^4$ are most preferably phenolic hydroxyl groups. $\alpha$ and $\beta$ each independently represents an integer of 0 to 10. In view of improving alkali-solubility, either $\alpha$ or$\beta$ is preferably an integer of 1 to 10, and more preferably an integer of 2 to 10. Y represents a monovalent organic group having at least one group selected from the group consisting of a carboxyl group, a phenolic hydroxyl group, a sulfonic acid group, and a thiol group. Z represents a divalent organic group having at least one group selected from the group consisting of a carboxyl group, a phenolic hydroxyl group, a sulfonic acid group, and a thiol group. The group included in Y and Z is most preferably a phenolic hydroxyl group. The number of carbon atoms of Y and Z is preferably 3 to 20.

The weight average molecular weight of the alkali-soluble polyimide is preferably 10, 000 or more and 100, 000 or less. When two or more kinds of soluble polyimides are included, the weight average molecular weight of at least one kind of them may be within the above range. The weight average molecular weight of 10,000 or more leads to an enhancement in mechanical strength of a hardened film and suppression of the generation of cracking in a thermal cycle test, thus making it possible to obtain high reliability. On the other hand, the weight average molecular weight of 100,

000 or less leads to an improvement in compatibility between (B) an epoxy compound and (C) a hardening accelerator mentioned below. In view of improving etching properties, weight average molecular weight is more preferably 50,000 or less. The weight average molecular weight in the present invention is measured by gel permeation chromatography (GPC) and is calculated in terms of polystyrene.

The alkali-soluble polyimide is obtained by the reaction of tetracarboxylic dianhydride with diamine. In the general formula (1), $R^1$ is a residue of tetracarboxylic dianhydride. $R^1$ is preferably an organic group having 8 to 40 carbon atoms, which has an aromatic group or a cyclic aliphatic group.

Specific examples of the tetracarboxylic dianhydride include aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorenic dianhydride, 9,9-bis{4-(3,4-dicarboxyphenoxy)phenyl}fluorenic dianhydride, 2,3,6,7-naphthalenetetracarboxylic dianhydride, 2,3,5,6-pyridinetetracarboxylic dianhydride, 3,4,9,10-perylenetetracarboxylic dianhydride, and 2,2-bis(3,4-dicarboxyphenyl)hexafluoropropane dianhydride; aliphatic tetracarboxylic dianhydrides such as butanetetracarboxylic dianhydride and 1,2,3,4-cyclopentanetetracarboxylic dianhydride; and acid dianhydrides having structures shown below. These tetracarboxylic dianhydrides are used alone, or two or more kinds thereof are used in combination:

[Chemical Formula 2]

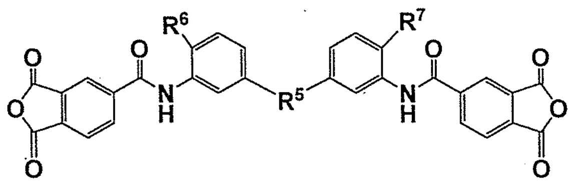

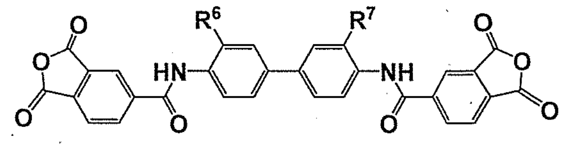

wherein $R^5$ represents a group selected from an oxygen atom, $C(CF_3)_2$, $C(CH_3)_2$, CO, COO, and $SO_2$. $R^6$ and $R^7$ may be the same or different and represent a group selected from a hydrogen atom, a hydroxyl group, and a thiol group.

In the general formula (1), $R^2$ is a residue of diamine. $R^2$ is preferably an organic group having 5 to 40 carbon atoms, which has an aromatic group or cyclic aliphatic group.

Specific examples of the diamine include 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenyl sulfide, 4,4'-diaminodiphenyl sulfide, 1,4-bis(4-aminophenoxy)benzene, 1,3-bis(4-aminophenoxy)benzene, 1,3-bis(3-aminophenoxy)benzene, benzidine, m-phenylenediamine, p-phenylenediamine, 1,5-naphthalenediamine, 2,6-naphthalenediamine, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, 2,2'-di(trifluoromethyl)-4,4'-diaminobiphenyl, and 9,9-bis(4-aminophenyl)fluorene; or compounds in which these aromatic rings are substituted with an alkyl group or a halogen atom, aliphatic cyclohexyldiamine, methylenebiscyclohexylamine, and diamines having structures shown below, and hese diamines are used alone, or two or more kinds thereof are used in combination:

[Chemical Formula 3]

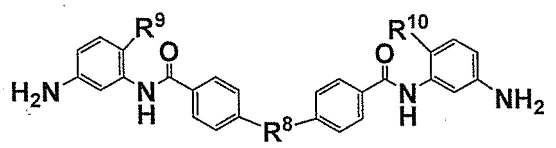
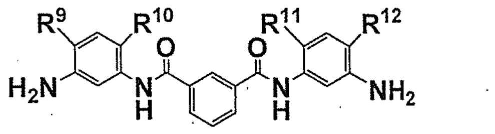
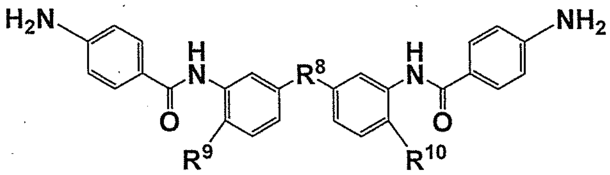
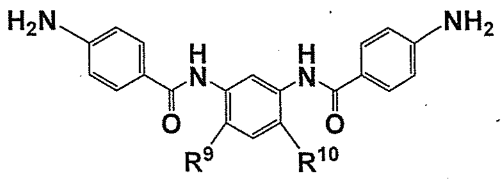
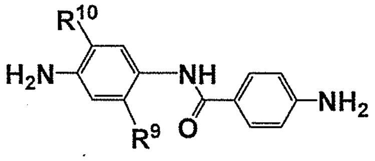
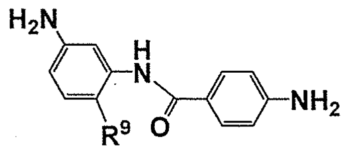

wherein $R^8$ represents a group selected from an oxygen atom, C $(CF_3)_2$, $C(CH_3)_2$, CO, COO, and $SO_2$. $R^9$ to $R^{12}$ may be the same or different and represent a group selected from a hydroxyl group and a thiol group.

Of these, preferred are 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylmethane, 3,3'-diaminodiphenylsulfone, 3,4'-diaminodiphenylsulfone, 4,4'-diaminodiphenylsulfone, 3,4'-diaminodiphenyl sulfide, 4,4'-diaminodiphenyl sulfide, m-phenylenediamine, p-phenylenediamine, 1,4-bis(4-aminophenoxy)benzene, 9,9-bis(4-aminophenyl)fluorene, and diamines having structures shown below:

[Chemical Formula 4]

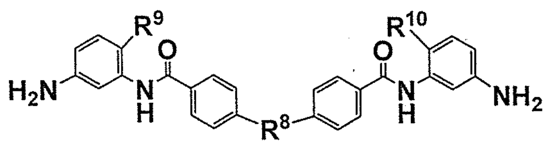
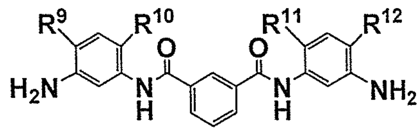
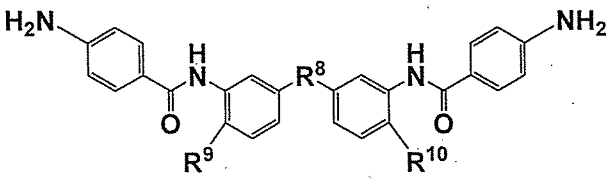
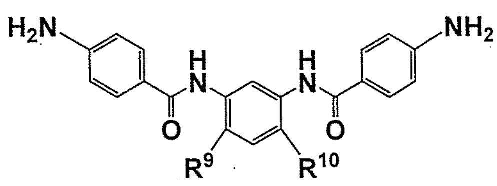

wherein $R^8$ represents a group selected from an oxygen atom, $C(CF_3)_2$, $C(CH_3)_2$, and $SO_2$. $R^9$ to $R^{12}$ may be the same or different and represent a group selected from a hydroxyl group and a thiol group.

In order to improve adhesion to the substrate, diamine including a siloxane structure may be copolymerized within a range not to cause deterioration of heat resistance. Specifically, bis(3-aminopropyl)tetramethyldisiloxane, bis(p-amino-phenyl)octamethylpentasiloxane, or the like may be copolymerized by 1 to 10 mol%.

In the alkali-soluble polyimide, at least part of the main chain terminal is sealed with a primary monoamine or a dicarboxylic anhydride. This terminal-sealing agent enables the adjustment of the weight average molecular weight of the alkali-soluble polyimide within an appropriate range. In view of improving alkali solubility, the terminal-sealing agent preferably has an alkali-soluble group.

In the general formula (2), Y is a residue of a primary monoamine which is a terminal-sealing agent. Specific

examples of the terminal-sealing agent are preferably, as primary monoamines, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonalphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, 4-aminothiophenol, and the like.

In the general formula (3), Z is a residue of a dicarboxylic anhydride which is a terminal-sealing agent. Specific examples of the dicarboxylic anhydride are preferably 4-carboxyphthalic anhydride, 3-hydroxyphthalic anhydride, cis-aconitic anhydride, and the like. These dicarboxylic anhydrides are used alone, or two or more kinds thereof are used in combination.

The alkali-soluble polyimide is synthesized by replacing a part of diamine by a primary monoamine which is a terminal-sealing agent, or replacing tetracarboxylic dianhydride by dicarboxylic anhydride which is a terminal-sealing agent, using a known method. A polyimide precursor is obtained by employing methods, for example, a method in which tetracarboxylic dianhydride, a diamine compound, and monoamine are reacted at low temperature, a method in which tetracarboxylic dianhydride, dicarboxylic anhydride, and an diamine compound are reacted at low temperature, a method in which a diester is obtained from tetracarboxylic dianhydride and an alcohol, and then diamine is reacted with monoamine in the presence of a condensing agent, and the like. Thereafter, a polyimide can be synthesized by employing a known imidization reaction method.

The alkali-soluble polyimide may be composed only of a structural unit represented by the general formula (1), or may be a copolymer with other structural units. In that case, the content of the structural unit represented by the general formula (1) is preferably 50 mol% or more, and more preferably 70 mol% or more, based on the whole polyimide. The kind and the amount of the structural unit used for copolymerization or mixing are preferably selected within a range not to cause deterioration of heat resistance of the polyimide obtained by a final heat treatment.

An imidization ratio of the alkali-soluble polyimide can be easily obtained, for example, by the following method. Here, the imidization ratio means what mol% of the polyimide precursor is converted into polyimide in the case of synthesizing polyimide via the polyimide precursor. First, an infrared absorption spectrum of the polymer is measured and then the presence of an absorption peak (at around 1,780 $cm^{-1}$, around 1,377 $cm^{-1}$) of an imide structure originating in polyimide is confirmed. Next, the polymer is subjected to a heat treatment at 350°C for 1 hour and the infrared absorption spectrum is measured again, followed by a comparison between a peak strength at around 1,377 $cm^{-1}$ before and after the heat treatment. Assuming that the imidization ratio of the polymer after the heat treatment as 100%, the imidization ratio of the polymer before the heat treatment. The imidization ratio of the polymer is preferably 90% or more.

The terminal-sealing agent introduced into the alkali-soluble polyimide can be detected by the following method. For example, the polyimide containing the terminal-sealing agent introduced thereinto is dissolved in an acidic solution, thereby decomposing into an amine component and a carboxylic anhydride component as constituent units of the polyimide, followed by measurement using gas chromatography (GC) and NMR. Separately, it is also detectable by directly measuring the polyimide containing the terminal-sealing agent introduced thereinto using pyrolysis gas chromatograph (PGC), infrared spectroscopy, $^{13}$CNMR, and the like.

In view of alkali etching property, the content of the alkali-soluble resin is preferably 10% by weight or more based on the whole amount of the organic substance of the alkali-soluble adhesive film, excluding the solvent and inorganic particles. The content of the alkali-soluble resin is preferably 20% by weight or more and 50% by weight or less. When using within this range, the alkali-soluble adhesive film is excellent in alkali etching property, and also the properties such as chemical resistance, heat resistance, and moisture resistance of the thus obtained hardened film are improved.

It is possible to use, as the epoxy compound (B), a liquid epoxy compound or a solid epoxy compound. Here, the liquid epoxy compound exhibits a viscosity of 150 Pa·s or less at 25°C. The solid epoxy compound exhibits a viscosity of more than 150 Pa·s at 25°C. Examples of the liquid epoxy compound include, but are not limited to, JER828, JER1750, JER152, JER630, and YL980 (which are trade names, manufacturedby Mitsubishi Chemical Corporation), Epiclon HP-4032 (which are trade names, manufactured by Dainippon Ink and Chemicals, Inc.); and EP-4000S, EP-4000L, EP-4003S, and EP-4010S (which are trade names, manufactured by Adeka Corporation). Two or more kinds thereof may be used in combination. Examples of the solid epoxy compound include, but are not limited to, JER1002, JER1001, YX4000H, JER4004P, JER5050, JER154, JER157S70, JER180S70, and YX4000H (which are trade names, manufactured by Mitsubishi Chemical Corporation); TEPIC S, TEPIC G, and TEPIC P (which are trade names, manufactured by Nissan Chemical Industries, Ltd.), Epotohto YH-434L (trade name, manufactured by NIPPON STEEL CHEMICAL CO., LTD.), EPPN 502H and NC 3000 (which are trade names, manufactured by Nippon Kayaku Co., Ltd.), EpiclonN695 and Epiclon HP-7200 (which are trade names, manufactured by Dainippon Ink and Chemicals, Inc.). Two or more kinds thereof may be used in combination.

In view of the adhesive strength, the content of the epoxy compound (B) is preferably 20% by weight or more based on the whole weight of the organic substance of the alkali-soluble adhesive film, excluding the solvent and inorganic particles. In view of improving fluidity when heated in the case of laminating the film on the base material, the content is more preferably 30% by weight or more. In view of the reflow resistance after hardening and insulation reliability under high temperature conditions, the content is preferably 80% by weight or less.

The alkali-soluble adhesive film preferably contains (C) a hardening accelerator. In view of the fact that, when the hardening accelerator does not dissolve in the alkali-soluble adhesive film but exists therein, the curing reaction of the epoxy compound proceeds slowly, thus improving storage stability at room temperature, the hardening accelerator (C) is preferably hardening accelerating particles.

The hardening accelerating particles to be used do not dissolve in each component contained in the alkali-soluble adhesive film. It is preferred to use imidazole-based hardening accelerating particles as the hardening accelerating particles since an adhesive film having excellent storage stability can be obtained by including a structure in which (D) inorganic particles are coordinated on the particle surface. It is possible to preferably use, as hardening accelerating particles, CUREZOL 2PZCNS, CUREZOL 2PZCNS-PW, CUREZOL C11Z-CNS, CUREZOL2MZ-A, CUREZOL C11-A, CUREZOL 2E4MZ-A, CUREZOL 2MZA-PW, CUREZOL 2MAOK-PW, and CUREZOL 2PHZ-PW (which are trade names, manufactured by SHIKOKU CHEMICALS CORPORATION).

Use of microcapsule type hardening accelerating particles enables further enhancement in storage stability. It is possible to preferably use, as the microcapsule type hardening accelerating particles, microcapsule type hardening accelerating particles obtained by treating an amine adduct type hardening accelerator with isocyanate.

It is preferred to use, as the microcapsule type hardening accelerating particles, those in which microcapsule type hardening accelerating particles exist in a state of being dispersed in a liquid epoxy compound. Examples of those in which microcapsule type hardening accelerating particles are in a state of being dispersed in a liquid epoxy compound include Novacure HX-3941HP, Novacure HXA3922HP, Novacure HXA3932HP, and Novacure HXA3042HP (which are trade names, manufactured by Asahi Kasei E-materials Corporation). In this case, a weight ratio of the microcapsule type hardening accelerating particles to the liquid epoxy resin is preferably as follows: the amount of the liquid epoxy compound is 100 parts by weight or more and 500 parts by weight or less based on 100 parts by weight of the microcapsule type hardening accelerating particles. For example, in Novacure (trade name, manufactured by Asahi Kasei E-materials Corporation) series, the liquid epoxy compound is contained in the amount of 200 parts by weight based on 100 parts by weight of the microcapsule type hardening accelerating particles. Accordingly, when Novacure (trade name, manufactured by Asahi Kasei E-materials Corporation) series are used as the microcapsule type hardening accelerating particles, the liquid epoxy compound contained in Novacure series is also contained as the epoxy compound (B) in the alkali-soluble adhesive film. The amount of hardening accelerating particles is the amount obtained by subtracting the weight of the liquid epoxy compound contained in Novacure series from the whole weight of Novacure series.

An average particle diameter of the hardening accelerating particles is preferably 0.5 $\mu$m to 5 $\mu$m. Here, the average particle diameter means the particle diameter when the hardening accelerating particles exist alone, and means the most common particle diameter. When the hardening accelerating particles have a spherical shape, the average particle diameter means the diameter and, when the hardening accelerating particles have an elliptical or flat shape, the average particle diameter means the maximum length of the shape. When the hardening accelerating particles have a rod or fibrous shape, the average particle diameter means the maximum length in the longitudinal direction. In the case of microcapsule type hardening accelerating particles, the average particle diameter means a particle diameter including the thickness of a capsule.

Other hardening accelerators may also be used in combination with hardening accelerating particles which are preferably used. Specific examples thereof include amine-based hardening accelerators, phosphine-based hardening accelerators, phosphonium-based hardening accelerators, sulfonium-based hardening accelerators, iodonium-based hardening accelerators, and the like.

The content of the hardening accelerator is preferably 0.1% by weight or more and 20% by weight or less based on the whole amount of the organic substance of the alkali-soluble adhesive film, excluding the solvent and inorganic particles. Control of the content of the hardening accelerator within this range enables long-term storage of the alkali-soluble adhesive film at room temperature and sufficient hardening of the alkali-soluble adhesive film. Control of the content of the hardening accelerator within this range enables well mixing of inorganic particles and hardening accelerator mentioned below, leading to uniform hardening, thus enhancing connection reliability of the semiconductor device fabricated using this alkali-soluble adhesive film. The hardening temperature/time is, for example, from 5 seconds to 20 minutes at the temperature of 160°C to 200°C, but is not limited thereto.

The alkali-soluble adhesive film preferably contains (D) inorganic particles. Inclusion of inorganic particles enables the adjustment of a melt viscosity of the alkali-soluble adhesive film within a range not to cause foaming in the case of thermal hardening of the alkali-soluble adhesive film. Since inorganic particles have a larger size than the molecular size of the organic compound, inorganic particles tend to be physically removed from the bump electrode in preference to the organic compound when the bump electrode is exposed using the adhesive sheet of the present

invention (see Fig. 1(b)). As a result, the content of the alkali-soluble resin in the adhesive residue left on the bump top increases as compared with the adhesive of other portions, thus making it easy to remove the residue on the bump top in the case of etching with an aqueous alkali solution.

Examples of inorganic particles (D) include silicates such as talc, calcined clay, uncalcined clay, mica, and glass; oxides such as titanium oxide, alumina, and silica; carbonates such as calcium carbonate and magnesium carbonate; hydroxides such as aluminum hydroxide, magnesium hydroxide, and calcium hydroxide; sulfates or sulfites, such as barium sulfate, calcium sulfate, and calcium sulphite; borates such as zinc borate, barium metaborate, aluminum borate, calcium borate, and sodium borate; and nitrides such as aluminum nitride, boron nitride, and silicon nitride. Plural kinds of inorganic particles may be contained, and silica or titanium oxide is preferable in view of reliability and costs. In order to improve dispersibility and settleability, these inorganic particles are more preferably subjected to a surface treatment with a silane coupling agent. The silane coupling agent is preferably a silane coupling agent having satisfactory compatibility with the resin component of the alkali-soluble adhesive film. The silane coupling agent is preferably a vinyl-based, methacryl-based, acrylic, epoxy-based, or amino-based silane coupling agent, and more preferably a vinyl-based, a methacryl-based, an acrylic, or epoxy-basedsilane coupling agent in view of the fact that the resin is covalently bonded with inorganic particles in the case of thermal hardening of the alkali-soluble adhesive film.

The content of inorganic particles (D) is preferably 40 parts by weight or more, and more preferably 100 parts by weight or more, based on 100 parts by weight of the whole amount of the organic substance of the alkali-soluble adhesive film, excluding the solvent and inorganic particles. The content of inorganic particles (D) of 40 parts by weight or more leads to suppression of foaming in the case of thermal hardening of the alkali-soluble adhesive film, thus improving connection reliability of the semiconductor device using this alkali-soluble adhesive film. When treatments requiring especially strong durability, like an absorption/reflow treatment and a thermal cycle treatment, are performed, it becomes possible to keep connection reliability. The content of inorganic particles (D) of 100 parts by weight or more leads to a decrease in a linear expansion coefficient after thermal hardening of the alkali-soluble adhesive film, resulting in more excellent connection reliability of the semiconductor device. The content of inorganic particles (D) is preferably 400 parts by weight or less in view of the fact that dispersibility of inorganic particles in the alkali-soluble adhesive film is improved and aggregation between inorganic particles is suppressed, thus improving connection reliability of the semiconductor device fabricated using this alkali-soluble adhesive film.

When using the alkali-soluble adhesive film in which the content of inorganic particles (D) is 40 to 100 parts by weight, adsorption flaw is not left on a surface of the alkali-soluble adhesive film in the case of transferring a semiconductor chip with an alkali-soluble adhesive film by a vacuum adsorption collet of a packaging device. It is also possible to suppress creeping up of the chip side face of the alkali-soluble adhesive film in the case of packaging of the semiconductor chip on a circuit board. Whereby, even if the thickness of the semiconductor chip becomes 100 μm or less due to backside cutting of the semiconductor wafer, it becomes possible to perform packaging without causing adhesion of the alkali-soluble adhesive film to the backside of the semiconductor chip and a heating tool of the packaging device.

The inorganic particles (D) may has any non-spherical shape such as spherical, granular, or flaky shape, and spherical inorganic particles can be preferably used since they are likely to be uniformly dispersed in the alkali-soluble adhesive film. The average particle diameter of spherical inorganic particles is preferably 10 nm to 3 μm, and more preferably 10 nm to 1 μm. When the average particle diameter is 10 nm to 3 μm, it is possible to fill into the alkali-soluble adhesive film in high concentration because of sufficiently excellent dispersibility. Therefore, the coordination number of inorganic particles to a surface of hardening accelerating particles sufficiently increases, leading to more excellent storage stability improving effect.

In case there is a need for the alkali-soluble adhesive film to have transparency, the particle diameter of inorganic particles (D) is preferably 100 nm or less, and more preferably 60 nm or less. For example, it is the case where there is a need to visually recognize a mark on the substrate face through the alkali-soluble adhesive film for the purpose of alignment after forming the alkali-soluble adhesive film on the substrate.

The average particle diameter of inorganic particles means a particle diameter when inorganic particles exist alone, and exhibits the most common particle diameter. The average particle diameter means the diameter when inorganic particles have a spherical shape, and means the maximum length when inorganic particles have an elliptical or flat shape. Furthermore, the average particle diameter means the maximum length in the longitudinal direction when inorganic particles have a rod or fibrous shape. It is possible to measure the average particle diameter of inorganic particles in the alkali-soluble adhesive film by a method in which the particles are directly observed by a scanning electron microscope (SEM) and an average of particle diameters of 100 particles is measured.

If necessary, the alkali-soluble adhesive film can contain a thermoplastic resin, organic particles, a crosslinking accelerator, an ion scavenger, an antioxidant, a colorant, a solubility modulator, a surfactant, a defoamer, and the like. The alkali-soluble adhesive film can also contain a silane coupling agent, a titanium chelating agent, and the like so as to enhance adhesion to a ground substrate such as a silicon wafer.

A method for fabricating an adhesive sheet of the present invention will be described below. First, an alkali-soluble adhesive composition (varnish) containing a component capable of forming an alkali-soluble adhesive film is

applied on a soft film serving as a support, and then optionally dried to obtain an adhesive sheet in which the alkali-soluble adhesive film is formed on a soft film. In this process, the soft film causes deformations such as shrinkage and elongation due to heating. Therefore, if it is difficult to apply a varnish, first, the varnish is applied on a film of polyethylene terephthalate (PET) on the film with peelability to form an alkali-soluble adhesive film, and the thus obtained alkali-soluble adhesive film may also be transferred onto the soft film due to heating lamination to form an alkali-soluble adhesive film on the soft film. The alkali-soluble adhesive composition can be obtained by adding an organic solvent capable of forming an alkali-soluble adhesive film. The organic solvent as'used herein may be any component capable of forming the alkali-soluble adhesive film.

Specific examples of the organic solvent include ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether, and ethylene glycol dibutyl ether; esters such as ethylene glycol monoethyl ether acetate, propylene glycol monomethyl ether acetate, propyl acetate, butyl acetate, isobutyl acetate, 3-methoxybutylacetate, 3-methyl-3-methoxybutylacetate, methyl lactate, ethyl lactate, and butyl lactate; ketones such as acetone, methyl ethyl ketone, acetylacetone, methyl propyl ketone, methyl butyl ketone, methyl isobutyl ketone, cyclopentanone, and 2-heptanone; alcohols such as butyl alcohol, isobutyl alcohol, pentanol, 4-methyl-2-pentanol, 3-methyl-2-butanol, 3-methyl-3-methoxybutanol, and diacetone alcohol; aromatic hydrocarbons such as toluene and xylene; and N-methyl-2-pyrrolidone, N-cyclohexyl-2-pyrrolidone, N,N-dimethylformamide, N,N-dimethylacetamide, dimethyl sulfoxide, γ-butyrolactone, and the like.

Examples of the method used to apply the alkali-soluble adhesive composition on the soft film include spin coating using a spinner, spray coating, roll coating, screen printing, blade coater, die coater, calendar coater, meniscus coater, bar coater, roll coater, comma roll coater, gravure coater, screen coater, slit die coater, and the like. The thickness of the coating film varied depending on the coating technique, the solid content of the composition, the viscosity, and the like. Usually, the film thickness is preferably 0.5 μm or more and 100 μm or less after drying.

Before application of the alkali-soluble adhesive composition, filtration may be performed using a filter paper or a filter. The filtration method is not particularly limited and is preferably a method in which filtration is performed by pressure filtration using a filter having a reserved particle diameter of 0.4 μm to 10 μm.

It is possible to use an oven, a hot plate, infrared rays, and the like, for drying. The drying temperature and the drying time may be within a range to vaporize an organic solvent, and it is preferred to appropriately set at a range where the alkali-soluble adhesive filmbecomes an unhardened or semihardened state. Specifically, drying is preferably performed at the temperature within a range of 40°C to 120°C for 1 minute to tens of minutes. The temperature may be raised in a stepwise manner in combination and, for example, a heat treatment may be performed at 70°C, 80°C, and 90°C for each 1 minute.

The adhesive sheet of the present invention may also include a protective film on the alkali-soluble adhesive film so as to protect a surface thereof. Whereby, it is possible to protect the surface of the alkali-soluble adhesive film from dirt and dust in the atmosphere.

Examples of the protective film include a polyester film, and the like. The protective film preferably exhibits small adhesion to the alkali-soluble adhesive film.

A method for production of a semiconductor device using the adhesive sheet of the present invention will be described below. In recent years, semiconductor devices having various structures have been proposed, and applications of the adhesive sheet of the present invention are not limited to the followings.

The method for production of a semiconductor device of the present invention includes the steps of: (1) laminating a face of the alkali-soluble adhesive film side of the adhesive sheet of the present invention on a face of the bump electrode side of a first circuit member including a bump electrode; (2) leaving only the alkali-soluble adhesive film of the adhesive sheet on the circuit member, and peeling other films included in the adhesive sheet; (3) etching the alkali-soluble adhesive film with an aqueous alkali solution to remove the adhesive on the bump electrode; and (4) electrically connecting the first circuit member with a second circuit member including a pad electrode by applying heat and pressure, in this order.

First, a first circuit member including a bump electrode and a second circuit member including a pad electrode are prepared. The shape and material of the bump electrode and the circuit member are as mentioned above. The pad electrode is an electrode provided on the second circuit member by correspondence to the position of the bump electrode provided on the first circuit member. The pad electrode may have a flat shape, or may be so-called pillar-shaped (columnar) projection. The planar shape of the pad electrode may be either a circular shape, or polygonal shape such as quadrangle or octagonal shape. There is no particular limitation on the material of the pad electrode, and it is possible to use metals which can be commonly used in the semiconductor device, such as aluminum, copper, titanium, tungsten, chromium, nickel, gold, solder, and alloys thereof, and also a plurality of metals can be laminated.

In the first step, on a face of a bump electrode of a first circuit member including a bump electrode, a face of the alkali-soluble adhesive film side of the adhesive sheet of the present invention is laminated. The case of lamination of an adhesive sheet on a first circuit member will be described in detail below.

First, when the adhesive sheet includes a protective film, the protective film is peeled. Then, an alkali-soluble adhesive film of an adhesive sheet is allowed to face a bump electrode of a first circuit member, followed by lamination due to thermal bonding. This state is a state shown in Fig. 1 (b). In this case, it is important that the bump electrode is exposed in a state where neither damage nor deformation exists in the bump electrode. Here, the state where the bump electrode is exposed means a state where the thickness of the alkali-soluble adhesive film after lamination is equivalent to or less than the height of the bump electrode.

Thermal bonding can be performed by a hot plate press treatment, a hot vacuumplate press treatment, a hot roll lamination treatment, a hot vacuum roll lamination treatment, and the like. A plurality of these thermal bonding treatments can also be used in combination. The lamination temperature is preferably 40°C or higher in view of adhesion to the substrate and embeddability. In order to prevent hardening of the alkali-soluble thermosetting resin composition film during lamination, and generation of a decrease in an etching rate and etching unevenness in the etching step, the lamination temperature is preferably 150°C or lower. When a flat adhesive coated film is required, a hot plate press treatment or a hot vacuum plate press treatment is preferably performed after lamination.

In the second step, only the alkali-soluble adhesive film of the adhesive sheet is left on the circuit member, and other films included in the adhesive sheet are peeled. In other words, when the adhesive sheet is composed of only the alkali-soluble adhesive film and the soft film, only the soft film is peeled. When the adhesive sheet includes, in addition to the alkali-soluble adhesive film and the soft film, other films, the soft film and other films are peeled. In this way, in a state where neither damage nor deformation exists in the bump electrode, there is obtained a circuit member, on which the alkali-soluble adhesive film is formed, in a state where the bump electrode is exposed. However, a small amount of an alkali-soluble adhesive is left on tops (bump tops) of the bump electrode. Fig. 1(c) corresponds to this state.

In the third step, the adhesive on bump tops is removed by alkali etching thereby putting into a state where no alkali-soluble adhesive exists on the bump tops. Alkali etching is performed by removing the alkali-soluble adhesive left on the bump tops using an alkali etchant. The alkali etchant is preferably an aqueous solution of an alkali compound such as tetramethylammonium, diethanolamine, diethylaminoethanol, sodium hydroxide, potassium hydroxide, sodium carbonate, potassium carbonate, triethylamine, diethylamine, methylamine, dimethylamine, dimethylaminoethyl acetate, dimethylaminoethariol, dimethylaminoethyl methacrylate, cyclohexylamine, ethylenediamine, or hexamethylenediamine. In some cases, these aqueous alkali compound solutions may contain organic solvents, for example, polar solvents such as N-methyl-2-pyrrblidone, N,N-dimethylformamide, N,N-dimethylacetamide, dimethyl sulfoxide, $\gamma$-butyrolactone, and dimethylacrylamide; alcohols such as methanol, ethanol, and isopropanol; esters such as ethyl lactate and propylene glycol monomethyl ether acetate ; and ketones such as cyclopentanone, cyclohexanone, isobutyl ketone, and methyl isobutyl ketone; alone, or a combination of several kinds of solvents thereof.

Alkali etching can be performed by a method in which the alkali etchant mentioned above is sprayed over an alkali-soluble adhesive coated film; a method in which the alkali etchant is sprayed while rotating a circuit member; a method in which the whole circuit member is immersed in the alkali etchant; or a method in which ultrasonic wave is applied while immersing the whole circuit member in the alkali etchant.

It is preferred that the conditions of the alkali etching step are adjusted so that the etching rate of the alkali-soluble adhesive film becomes 0.5 $\mu$m/minute or more and 100 $\mu$m/minute or less in view of the fact that a resin on bump tops can be easily etched and also it becomes easy to control the amount of etching of the portion where the adhesive is desirably left. The etching rate is more preferably 1.0 $\mu$m/minute or more. The etching rate is still more preferably 50 $\mu$m/minute or less, and most preferably 10 $\mu$m/minute or less. The etching rate can be adjusted by the kind, the temperature, and the concentration of the alkali etchant. The etching rate ($\mu$m/minute) canbe calculated by measuring a change in film thickness ($\mu$m) of the alkali-soluble adhesive film before and after the etching step, and dividing the change by the etching time (minute).

The temperature of the alkali etchant is preferably within a range of 20 to 50°C. The etching time is preferably 5 seconds or more in view of stability of the process, and preferably within 5 minutes in view of improving productivity.

After alkali etching, a rinsing treatment may be performed using water. The rinsing treatment can be performed by various methods used in the alkali etching treatment using an alkali etchant in place of water. The rinsing treatment may be performed by adding organic acids, for example, alcohols such as ethanol, isopropyl, and alcohol, and esters such as ethyl lactate and propylene glycol monomethyl ether acetate to water.

In order to adjust the alkali etching rate, it is possible to include the step of subjecting a circuit member to a baking treatment before an alkali etching treatment. The temperature of the baking treatment is preferably within a range of 50 to 180 °C, and more preferably60 to 120°C. The time of the baking treatment is preferably 5 seconds to several hours.

After the alkali etching treatment, heat drying is preferably performed within a range of 60 to 200 °C in view of reducing a solvent, a volatile component, water, and the like left in an alkali-soluble adhesive coated film. The heat drying time is preferably 1 minute to several hours.

In this way, the adhesive on the bump electrode is removed by alkali etching to obtain a circuit member with a bump electrode in which an alkali-soluble adhesive film is formed, no alkali-soluble adhesive existing on bump tops. Fig. 1(d) corresponds to this state.

In the fourth step, by the method mentioned above, a first circuit member including a bump electrode on which an alkali-soluble adhesive coated film is formed, and a second circuit member including a pad electrode are disposed while facing the bump electrode and the pad electrode to each other. Thereafter, the first circuit member is electrically connected to the second circuit member by applying heat and pressure. Using a circuit member including a connection terminal on both sides, that is, both-sided wiring board, the above-mentioned connection is repeatedly performed to obtain a semiconductor device in which circuit members are three-dimensionally laminated.

Since an adhesive on bump tops could not be completely removed in the prior art, the adhesive is interposedbetween a bump electrode and a pad electrode in the case of electrically connecting the first circuit member to the second circuit member, leading to deterioration of connection reliability of the semiconductor device. According to the method for production of a semiconductor device of the present invention, it is possible to completely remove the adhesive on bump tops, thus making it possible to obtain a semiconductor device in which no adhesive is interposed between electrodes in the case of electrically connecting the first circuit member to the second circuit member. Accordingly, it is possible to produce a semiconductor device which is excellent in connection reliability.

[Examples]

The present invention will be specifically described below by way of Examples, but the present invention is not limited thereto.

<Imidization Ratio of Synthesized Polyimide>

First, an infrared absorption spectrum of a polymer obtained by synthesis was measured, thus confirming the presence of absorption peaks (around 1, 780 $cm^{-1}$, around 1, 377 $cm^{-1}$) of an imide structure attributed to polyimide. After the polymer was subjected to a heat treatment at 350°C for 1 hour, the infrared absorption spectrum was measured again and then a comparison was made between peak strengths at around 1, 377 $cm^{-1}$ before and after the heat treatment. Assuming that an imidization ratio of the polymer after the heat treatment is 100%, an imidization ratio of the polymer before the heat treatment was determined.

<Evaluation of Alkali Solubility of Synthesized Polyimide>

When 0.1 g or more of the synthesized polyimide powder was dissolved in 100 g of an aqueous 2.38% solution of tetramethylammonium hydroxide at 25°C, it was evaluated as alkali-soluble, and others were evaluated as alkali-insoluble.

<Molecular Weight of Synthesized Polyimide>

The synthesized polyimide was dissolved in N-methyl-2-pyrrolidone (hereinafter referred to as NMP) to prepare a solution having a solid component concentration of 0.1% by weight, which was used as a measuring sample. Using a GPC system Waters 2690 (manufactured by Waters Corporation), polystyrene-equivalent weight average molecular weight was calculated.. GPC measuring conditions are as follows: NMP dissolved in each of LiCl and phosphoric acid in the concentration of 0.05 mol/L was used as a mobile phase, and a flow rate was set at 0.4 mL/minute. A column was warmed to 40°C, using a column oven.

Detector: Waters 996
System controller: Waters 2690
Column: TOSOH TSK-GEL α-4000
Column: TOSOH TSK-GEL α-2500.

<Measurement of Etching Rate>

The etching rate of an alkali-soluble adhesive film was evaluated in the following manner. A protective film was peeled from adhesive sheets produced in the respective Examples and Comparative Examples, and then laminated on a bare silicon substrate using a laminator (MVLP600, manufactured by Meiki Co., Ltd.) under the conditions of the heating platen temperature of 80°C, the vacuum drawing time of 20 seconds, the press pressure of 0.5 MPa, and the press time of 60 seconds. In that case, the alkali-soluble adhesive film of the adhesive sheet was brought into contact with a silicon substrate.

A support with a soft layer was peeled from the adhesive sheet to obtain a silicon substrate on which an adhesive coated film is formed. Using a probe type step profiler, a film thickness ($T_1$) of an adhesive film was measured. Subsequently, dip etching was performed at 23°C for 30 seconds using an aqueous 2.38% solution of tetramethylammonium hydroxide as an etchant, followed by a rinsing treatment with water. Using a probe type step profiler, film thickness ($T_2$) of the adhesive film was measured after etching. The etching rate was calculated by the following equation.

$$\text{Etching rate } (\mu\text{m/minute}) = (T_1 - T_2)/0.5$$

<Observation of Bump Tops>

A protective film of adhesive sheets fabricated in the respective Examples and Comparative Examples was peeled, and the peeled surface was laminated on a daisy chain silicon substrate on which a Cu pillar solder bump (Cu height: 20 μm, solder cap height: 20 μm, bump diameter: 50 μm, bump pitch: 100 μm) was formed using a laminator (MVLP600, manufactured by Meiki Co., Ltd.) under the conditions of the heating platen temperature of 80°C, the vacuum drawing time of 20 seconds, the press pressure of 0.5 MPa, and the press time of 60 seconds.

The support with a soft layer of the adhesive sheet was peeled to obtain a silicon substrate on which an adhesive coated film is formed. Subsequently, using an aqueous 2.38% solution of tetramethylammonium hydroxide, dip etching was performed at 23°C for 30 seconds, followed by a rinsing treatment with water. Thereafter, using SEM, any bump top of the silicon substrate was observed at a magnification of 1,500 times. In the obtained SEM images, the shape of the bump was visually observed. The case where neither damage nor deformation was observed in the bump was rated "Good", while the case where damage and deformation of the bump were observed was rated "Poor". In the SEM images, the residue of the adhesive on bump tops was visually observed. The case where no adhesive was observed on bump tops was rated "Good", while the case where the adhesive was observed on bump tops was rated "Poor".

<Reliability Test>

The silicon substrate on which an adhesive coated film is formed in the above manner was fixed on a dicing tape attached to a tape frame. Fixing was performed by laminating a dicing tape (D-650, manufactured by Lintec Corporation) on a wafer substrate surface on the opposite side of a bump electrode using a wafer mounter (FM-114, manufactured by TECHNOVISION, INC.). Next, blade dicing was performed under the following cutting conditions to obtain a single semiconductor chip (7.3 mm square). Dicing device: DAD-3350 (manufactured by DISCO Corporation)

Semiconductor chip size: 7.5 × 7.5 mm
Blade: NBC-ZH2040-SE27HDEF
Spindle speed: 30,000 rpm
Cutting speed: 25 mm/s
Cutting depth: cut into a depth of 10 μm of a dicing tape
Cut: One-path full cut
Cut mode: Down cut
Amount of cutting fluid: 3.7 L/minute
Cutting fluid and cooling fluid: temperature of 23°C, electric conductivity of 0.5 MΩ·cm (carbonic acid gas is poured into ultrapure water).

Next, using a flip-chip bonder (FC-3000, manufactured by Toray Engineering Co. , Ltd.), a printed circuit board (PCB) serving as an adherend was allowed to undergo flip chip bonding of the semiconductor chip with an alkali-soluble adhesive film. Regarding flip chip bonding, the semiconductor chip was fixed on a bonding stage heated at 100°C, followed by pre-bonding on PCB under the conditions of the temperature of 100°C, the pressure of 15 N/chip, and the time of 10 seconds, and further bonding under the conditions of the temperature of 250°C, the pressure of 200 N/chip, and the time of 20 seconds to obtain a semiconductor device. Thereafter, five semiconductor devices thus obtained were maintained at -50°C for 5 minutes and maintaining at 125°C for 5 minutes (1 cycle), and then 1,000 cycles were carried but. Thereafter, electrical resistivity of the semiconductor device was measured and the number of measurable semiconductor devices was examined.

Polyimides used in the respective Examples and Comparative Examples were synthesized by the following method.

Synthesis Example 1

Under dry nitrogen gas flow, 30.95 g (0.0845 mol) of 2,2-bis(3-amino-4-hydroxyphenyl)hexafluoropropane

(hereinafter referred to as BAHF) and 1.24 g (0.005 mol) of 1,3-bis(3-aminopropyl)tetramethyldisiloxane were dissolved in 100 g of N-methyl-2-pyrrolidone (hereinafter referred to as NMP) . To the solution, 31.02g (0.1mol) of bis (3,4-dicarboxyphenyl) ether dianhydride (hereinafter referred to as ODPA) was added, together with 30 g of NMP, followed by stirring at 20°C for 1 hour and further stirring at 50°C for 4 hours. To the mixture, 2.5 g (0.02 mol) of 3-aminophenol was added at 50°C for 2 hours, followed by stirring at 180°C for 5 hours to obtain a resin solution. Next, 3 L of water of a resin solution was poured to obtain a white precipitate. This precipitate was collected by filtration, washed three times with water, and then dried in a vacuum dryer at 80°C for 5 hours. The thus obtained resin powder exhibited an imidization ratio of 94% and was alkali-soluble. The obtained resin had a weight average molecular weight of 25,600.

Synthesis Example 2

Under dry nitrogen gas flow, 11.41 g (0.057 mol) of 4,4'-diaminodiphenyl ether, 1.24 g (0.005 mol) of 1,3-bis(3-aminopropyl)tetramethyldisiloxane, and 6.98 g (0.075 mol) of aniline as a terminal-sealing agent were dissolved in 100 g of NMP. To the solution, 31.02 g (0.1 mol) of ODPA was added, together with 30 g of NMP, followed by stirring at 20°C for 1 hour and further stirring at 50°C for 4 hours. Thereafter, 15 g of xylene was added, followed by stirring at 180°C for 5 hours while performing the azeotropic reaction of water with xylene. After completion of stirring, the solution was poured into 3 L of water to obtain a white precipitate. This precipitate was collected by filtration, washed three times with water, and then dried in a vacuum dryer at 80°C for 5 hours. The thus obtained resin powder exhibited an imidization ratio of 94% and was alkali-insoluble. The obtained resin had a weight average molecular weight of 11,000.

The components (B) to (D) used in the respective Examples and Comparative Examples are as follows.

EP-4000S: PO-modified bisphenol A type epoxy (trade name, manufactured by Adeka Corporation)
835-LV: Bisphenol F type epoxy (trade name, manufactured by Dainippon Ink and Chemicals, Inc.)
N-865: Modified novolak type epoxy (trade name, manufactured by Dainippon Ink and Chemicals, Inc.) 2MAOK-PW: Imidazole-based hardening accelerating particles (trade name, manufactured by SHIKOKU CHEMICALS CORPORATION)
HX-3941: Microcapsule type hardening accelerating particles (trade name, manufactured by Asahi Kasei E-materials Corporation)
SE-2050KNK: Silica slurry (trade name, manufactured by Admatechs Company Limited), average particle diameter of 0.5 μm, spherical silica, methyl isobutyl ketone dispersion of 70% by weight silica).

Example 1

Polyimide (30 g) obtained in Synthesis Example 1 as a component (A), 50 g of EP-4000S as a component (B), 15 g of N865, 5 g of 2MAOK-PW as a component (C), and 214 g (amount of silica particles is as follows: $214 \times 0.7 = 150$ (g)) of SE-2050-KNK as a dispersion containing a component (D), and 19 g of methyl isobutyl ketone as an organic solvent were compounded to obtain an alkali-soluble adhesive composition having a solid component concentration of 75%, additives other than the solvent being a solid component. The thus obtained adhesive composition was applied on a support using a comma roll coater, and then dried at 90°C for 10 minutes to obtain an adhesive sheet. Using EVA/PET (trade name, TAKARAINC. CO., Ltd.) as the support, the adhesive composition was applied on the EVA surface. EVA/PET is a support with a soft layer obtained by laminating a 30 μm thick EVA film as a soft film with a 75 μm thick PET film as a hard film, and the total thickness of that of EVA and that of PET is 105 μm. The alkali-soluble adhesive film had a thickness of 30 μm after drying. On the alkali-soluble adhesive film, a 25 μm thick polyethylene terephthalate film SR-1 (trade name, manufactured by OHTSUKI INDUSTRIAL CO. , Ltd.) was laminated as a protective film to obtain an adhesive sheet with a protective film. Using the thus obtained adhesive sheet, observation of bump tops and a reliability test were carried out, as mentioned above. The results are shown in Table 2.

Examples 2 to 4

In the same manner as in Example 1, except that the thickness of the support with a soft layer and the amounts of components (A) to (D) were changed as shown in Table 1, adhesive sheets were fabricated, and observation of bump tops and a reliability test were carried out. The results are shown in Table 2.

Example 5

In the same manner as in Example 1, except that PE/PET (trade name, manufactured by FUJIMORI SANGYO CO., Ltd.) was used as the support with a soft layer and an adhesive composition was applied on the PE surface, an adhesive sheet was fabricated, and observation of bump top and a reliability test were carried out. The results are shown

in Table 2. PE/PET is a support with a soft layer obtained by laminating a 50 μm thick PE film as a soft film with a 75 μm thick PET film as a hard film, and the total thickness of that of PE and that of PET is 125 μm.

Comparative Example 1

In the same manner as in Example 1, except that polyimide of Synthesis Example 2 was used in place of polyimide of Synthesis Example 1, an adhesive sheet was fabricated, and observation of bump tops and a reliability test were carried out. The results are shown in Table 2.

Comparative Example 2

In the same manner as in Example 1, except that a support composed only of PET was used in place of the support with a soft layer, an adhesive sheet was fabricated, and observation of bump tops and a reliability test were carried out. The results are shown in Table 2.

[Table 1]

| | | Example 1 | Example 2 | Example 3 | Example 4 | Example 5 | Comparative Example 1 | Comparative Example 2 |
|---|---|---|---|---|---|---|---|---|
| Kind and thickness of support with soft layer or support | | EVA/PET | EVA/PET | EVA/PET | EVA/PET | PE/PET | EVA/PET | PET |
| | | 30 μm/75 μm | 30 μm/75 μm | 50 μm/75 μm | 30 μm/75 μm | 50 μm/75 μm | 30 μm/75 μm | 75 μm |
| Component (A) | Polyimide of Synthesis Example 1 (g) | 30 | 30 | 30 | 30 | 30 | - | 30 |
| | Polyimide of Synthesis Example 2 (g) | - | - | - | - | - | 30 | - |
| Component (B) | EP-4000S (g) | 50 | 35 | 50 | - | 50 | 50 | 50 |
| | 835-LV (g) | - | - | - | 65 | - | - | - |
| | N-865 (g) | 15 | 15 | 15 | - | 15 | 15 | 15 |
| Component (C) | 2MAOK-PW (g) | 5 | - | 5 | 5 | 5 | 5 | 5 |
| | HX-3941 (g) | - | 20 | - | - | - | - | - |
| Component (D) | SE-2050KNK (g) (Spherical silica (g))[1)] | 214 (150) | 2·14 (150) | 214 (150) | 214 (150) | 214 (150) | 214 (150) | 214 (150) |
| ( (D)/((A)+(B)+(C)) × 100 (%)[2)] | | 150 | 150 | 150 | 150 | 150 | 150 | 150 |

1) SE-2050KNK is a methyl isobutyl ketone dispersion of 70% by weight silica and a numerical value in parentheses is the amount of the component (D).
2) Proportion of component (D) to the total amount of components (A) to (C) (%)

[Table 2]

| | Etching rate (μm/minute) | Shape of bump | Residue of adhesive on bump tops | Reliability test (Pieces) |
|---|---|---|---|---|
| Example 1 | 7.8 | Good | Good | 5 |
| Example 2 | 2.2 | Good | Good | 5 |
| Example 3 | 7.8 | Good | Good | 5 |
| Example 4 | 4.1 | Good | Good | 5 |
| Example 5 | 7.8 | Good | Good | 5 |
| Comparative Example 1 | 0.1 | Good | Poor | 3 |
| Comparative Example 2 | 7.8 | Poor | Good | 1 |

[Reference Signs List]

100: Circuit member with bump electrode

101: Copper pillar

102: Solder bump

103: Alkali-soluble adhesive film

104: Soft film

10.5: Alkali-soluble adhesive left on bump tops

[Industrial Applicability]

When the adhesive sheet of the present invention is laminated on a semiconductor chip with bump electrode, it is possible to expose a bump electrode without imparting damage to the bump electrode. Then, wet etching of an adhesive on bump tops using an aqueous alkali solution makes it possible to put into a state where no adhesive exists on the bump tops, thus enabling the production of a semiconductor device which is excellent in connection reliability between the semiconductor chip and the circuit board after flip chip packaging.

## Claims

1. An adhesive sheet for production of a semiconductor device with bump electrode, comprising a soft film and an alkali-soluble adhesive film formed on the soft film.

2. The adhesive sheet for production of a semiconductor device with bump electrode according to claim 1, wherein the soft film is a polyethylene film or an ethylene-vinyl acetate copolymer film.

3. The adhesive sheet for production of a semiconductor device with bump electrode according to claim 1 or 2, wherein the alkali-soluble adhesive film contains(A)an alkali-solubleresin, (B) an epoxy compound, (C) a hardening accelerator, and (D) inorganic particles.

4. The adhesive sheet for production of a semiconductor device with bump electrode according to claim 3, wherein the alkali-soluble resin (A) is an alkali-soluble polyimide.

5. The adhesive sheet for production of a semiconductor device with bump electrode according to claim 4, wherein the alkali-soluble polyimide includes a structural unit represented by the following general formula (1) and also includes structure (s) represented by the following general formula(s) (2) and/or (3) in at least one main chain terminal:

[Chemical Formula 1]

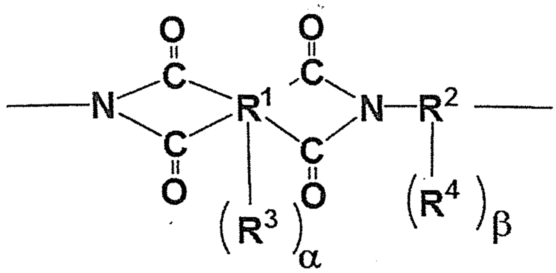

(1)

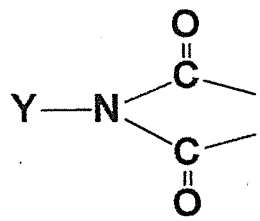

(2)

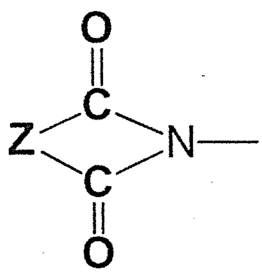

(3)

wherein $R^1$ represents tetra- to tetradecavalent organic groups; $R^2$ represents di- to dodecavalent organic groups; $R^3$ and $R^4$ may be the same or different and represent at least one group selected from the group consisting of a carboxyl group, a phenolic hydroxyl group, a sulfonic acid group, and a thiol group; $\alpha$ and $\beta$ each independently represents an integer of 0 to 10; Y represents a monovalent organic group having at least one group selected from the group consisting of a carboxyl group, a phenolic hydroxyl group, a sulfonic acid group, and a thiol group; and Z represents a divalent organic group having at least one group selected from the group consisting of a carboxyl group, a phenolic hydroxyl group, a sulfonic acid group, and a thiol group; in the above general formulas (1) to (3).

6. The adhesive sheet for production of a semiconductor device with bump electrode according to claim 4 or 5, wherein the alkali-soluble polyimide has a phenolic hydroxyl group.

7. The adhesive sheet for production of a semiconductor device with bump electrode according to any one of claims 1 to 6, wherein the rate of etching of the alkali-soluble adhesive film with an aqueous 2.38% tetramethylammonium

hydroxide solution at 23°C is 0.5 to 100 μm/minute.

**8.** A method for production of a semiconductor device, which comprises the steps of:

laminating a face of the alkali-soluble adhesive film side of the adhesive sheet for production of a semiconductor device with.bump electrode according to any one of claims 1 to 7 on a face of the bump electrode side of a first circuit member including a bump electrode;
leaving only the alkali-soluble adhesive film of the adhesive sheet on the circuit member, and peeling other films included in the adhesive sheet;
etching the alkali-soluble adhesive film with an aqueous alkali solution to remove the adhesive on the bump electrode; and
electrically connecting the first circuit member with a second circuit member including a pad electrode by applying heat and pressure, in this order.

**9.** The method for production of a semiconductor device according to claim 8, wherein the etching rate in the step of etching the alkali-soluble adhesive film is 0.5 to 100 μm/minute.

Fig. 1

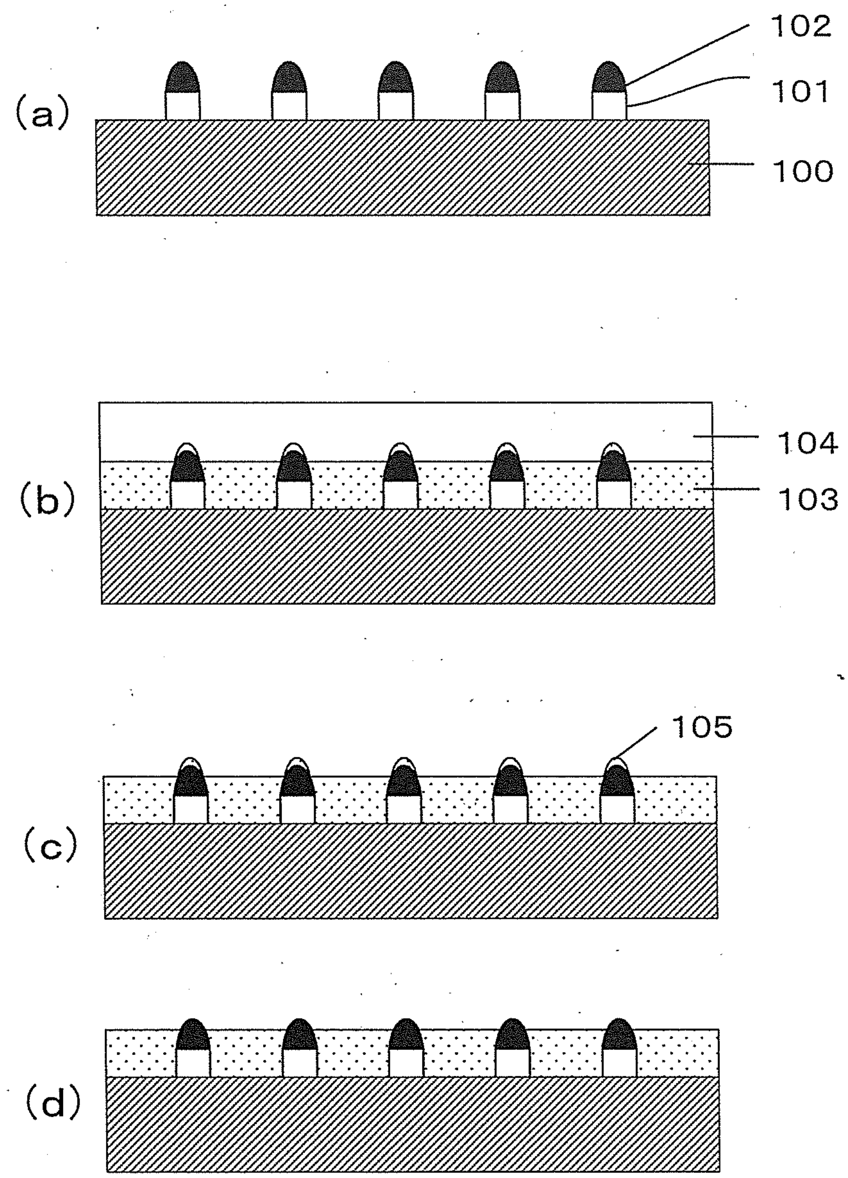

## INTERNATIONAL SEARCH REPORT

International application No.
PCT/JP2013/064036

A. CLASSIFICATION OF SUBJECT MATTER
*C09J7/02*(2006.01)i, *C09J11/04*(2006.01)i, *C09J11/06*(2006.01)i, *C09J163/00*(2006.01)i, *C09J179/08*(2006.01)i, *H01L21/60*(2006.01)i, *H01L23/29*(2006.01)i, *H01L23/31*(2006.01)i

According to International Patent Classification (IPC) or to both national classification and IPC

B. FIELDS SEARCHED

Minimum documentation searched (classification system followed by classification symbols)
C09J7/02, C09J11/04, C09J11/06, C09J163/00, C09J179/08, H01L21/60, H01L23/29, H01L23/31

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2012/005079 A1 (Toray Industries, Inc.), 12 January 2012 (12.01.2012), claims 1, 3; paragraphs [0061] to [0063], [0069], [0078], [0091], [0098], [0105] to [0110] & US 2013/0105998 A1 & EP 2592126 A1 & CN 102985505 A | 1-9 |
| Y | JP 2010-258239 A (Sekisui Chemical Co., Ltd.), 11 November 2010 (11.11.2010), claim 1; paragraphs [0003], [0010] to [0014], [0068], [0077] (Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 August, 2013 (12.08.13) | 27 August, 2013 (27.08.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/064036

C (Continuation). DOCUMENTS CONSIDERED TO BE RELEVANT

| Category* | Citation of document, with indication, where appropriate, of the relevant passages | Relevant to claim No. |
|---|---|---|
| A | WO 2011/049011 A1 (Toray Industries, Inc.), 28 April 2011 (28.04.2011), claim 1; paragraphs [0058], [0069], [0094] & US 2012/0181709 A1 & EP 2492331 A1 & CN 102575139 A & KR 10-2013-0026524 A | 1-9 |
| A | JP 2009-277818 A (Toray Industries, Inc.), 26 November 2009 (26.11.2009), claim 1; paragraph [0032] (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005028734 A
- JP 2011171586 A